# EUROPÄISCHE PATENTSCHRIFT

(11) **EP 1 999 291 B1**
(45) Veröffentlichungstag und Bekanntmachung des Hinweises auf die Patenterteilung: **11.04.2012**
(21) Anmeldenummer: 07710508.8
(22) Anmeldetag: 09.03.2007
(51) Int. Cl.: C23C 14/24, C22C 12/00

(54) **ALKALIMETALLVERDAMPFERQUELLE**
ALKALI METALL VAPORISING SOURCE
SOURCE DE VAPORISATION DE MÉTAUX ALCALINS

(30) Priorität: 24.03.2006 AT 5072006
(43) Veröffentlichungstag der Anmeldung: 10.12.2008
(73) Patentinhaber: Alvatec Production and Sales GesmbH, 9330 Althofen (AT)
(72) Erfinder: OGRIS, Erhard, A-9330 Althofen (AT); SCHEBESTA, Sebastian, A-9330 Althofen (AT); GROSSINGER, Artur, A-9330 Althofen (AT); DENGG, Florian, A-9571 Simitz (AT)
(74) Vertreter: Wirnsberger, Gernot
(86) Internationale Anmeldenummer: PCT/AT2007/000118
(87) Internationale Veröffentlichungsnummer: WO 2007/109815

(56) Entgegenhaltungen:
- AT-B- 410 947
- US-A- 3 858 955
- FRANZISKA EMMERLING, NINA LÄNGIN, DENIS PETRI, MARTIN KROEKER, CAROLINE RÖHR: "Alkalimetallbismutide ABi und ABi2 (A = K, Rb, Cs) - Synthesen, Kristallstrukturen, Eigenschaften" ZEITSCHRIFT FÜR ANORGANISCHE UND ALLGEMEINE CHEMIE, Bd. 630, Nr. 1, Januar 2004 (2004-01), Seiten 171-178, XP002433478

## Beschreibung

Die Erfindung betrifft eine Verdampferquelle zum Erzeugen einer Gasphase, die zumindest ein Alkalimetall aufweist oder aus diesem besteht.

Weiter betrifft die Erfindung eine Vorrichtung zum Umsetzen einer Substanz mit einer Gasphase, welche zumindest ein Alkalimetall aufweist oder aus diesem besteht.

Schließlich betrifft die Erfindung eine Verwendung einer Legierung.

Gasförmige Alkalimetalle und Erdalkalimetalle in reiner Form oder gegebenenfalls im Gemisch mit einem chemisch inerten Trägergas werden für die Herstellung einer Reihe von speziellen Produkten im Hochtechnologiebereich benötigt. Beispielsweise werden organische Leuchtdioden häufig mit Alkalimetallen dotiert, wobei eine Einbringung des Alkalimetalls in den organischen Feststoff über die Gasphase erfolgt. Eine andere Anwendung insbesondere von hochreinen gasförmigen Alkalimetallen betrifft eine Herstellung von Fotokathoden, für welche auf Grund einer niedrigen Austrittsarbeit vor allem Natrium, Kalium, Rubidium und Cäsium eingesetzt werden.

Die genannten und weitere Herstellungsverfahren, bei welchen gasförmige Alkalimetalle oder Erdalkalimetalle verwendet werden, werden in der Regel mit Hilfe einer Verdampferquelle durchgeführt, die in einer Hochvakuumvorrichtung untergebracht ist. Dies erlaubt es, vor Erzeugung eines Alkalimetall- bzw. Erdalkalimetalldampfes ein Hochvakuum von 10⁻⁵ mbar oder besser einzustellen, was zur Ausbildung einer reinen Alkalimetall- oder Erdalkalimetall-Gasphase beiträgt.

Ungünstigerweise können Alkalimetalle bzw. Erdalkalimetalle für die erwähnten Zwecke nicht in elementarer Form eingesetzt und verdampft werden, da eine langsame und kontrollierte Verdampfung erforderlich ist und Hochvakuumvorrichtungen - und damit auch Verdampferquellen - unter Hochvakuum bei möglichst hohen Temperaturen, gemäß dem Stand der Technik zumindest etwa 150 °C, ausgeheizt werden sollen, um beispielsweise Wasser oder andere reaktive Substanzen aus der Vakuumvorrichtung zu entfernen. Insbesondere Rubidium und Cäsium stellen diesbezüglich problematische Elemente dar, weil sie im Hochvakuum bereits bei sehr niedrigen Temperaturen verdampfen, nämlich bei einem Druck von 10⁻⁶ mbar etwa zwischen 20 und 50 °C. Alkalimetalle in elementarer Form sind überdies äußerst reaktiv und daher schwer handzuhaben.

Gemäß dem Stand der Technik sind Verdampferquellen bekannt, welche Cäsiumverbindungen wie Cäsiumchromate, Cäsiummolybdate, Cäsiumwolframate oder Cäsiumniobate im Gemisch mit einem Reduktionsmittel enthalten. Bei einer hohen Temperatur reduziert das Reduktionsmittel die Cäsiumverbindung und es wird gasförmiges Cäsium freigesetzt (EP 1 419 542 A2). Verdampferquellen auf dieser Basis weisen allerdings die Nachteile auf, dass die genannten Cäsiumverbindungen hygroskopisch sind und Zusammensetzungen solcher Verdampferquellen niedrige Gewichtsanteile der genützten Alkalimetalle aufweisen.

Bekannt ist es auch, Alkalimetalle bzw. Erdalkalimetalle mit einer Schutzbeschichtung aus beispielsweise Gallium, Indium oder Bismut zu versehen (AT 410 947 B). Solche Materialien geben unter Umständen Alkali- oder Erdalkalimetall erst bei erhöhten Temperaturen, bei welchen die Schutzbeschichtung als Schmelze vorliegt, ab. Allerdings ist eine gezielte Freisetzung von Alkali- bzw. Erdalkalimetall schwierig erreichbar, da Beginn bzw. Ende eines Freisetzens an den Aggregatzustand der Schutzschicht (fest oder flüssig) gekoppelt sind. Überdies erfordert ihre Herstellung ein aufwändiges Verfahren.

Weiter sind Verdampferquellen aus Legierungen eines Alkalimetalls mit weiteren Metallen bekannt. Bei diesen Verdampferquellen kann das Alkalimetall aus dem Gitterverband der Legierung heraus sublimiert werden (RU 2056661 C1). Bei diesen ausschließlich metallischen Alkaliverdampferquellen der allgemeinen Formel AₙBₘ, wobei A gleich ein beliebiges Alkalimetall ist, B für Indium, Zinn oder Gallium steht und n und m > 1 sind, treten allerdings auch Nachteile auf: Erstens sublimiert das Alkalimetall im Hochvakuum bei Temperaturen, welche unter den üblichen Ausheiztemperaturen von Hochvakuumvorrichtungen (in der Regel zumindest etwa 150 °C) liegen, was deren Anwendbarkeit für solche Zwecke limitiert. Zweitens hat man bei Normaldruck keine stabile Schmelze, weil bei Schmelztemperaturen und unter Normaldruck das Alkalimetall aus der Schmelze verdampft. Dies erschwert eine Verarbeitung derartiger Schmelzen bzw. eine Herstellung von Verdampferquellen.

Aus der US 3,858,955 ist eine Kathode bekannt geworden, die zur Aktivierung einem Cäsiumdampf ausgesetzt wird. Zu diesem Zweck ist innerhalb der evakuierten Kathode eine etwa 10 µm dicke Antimonlage vorgesehen, auf welche Cäsium aufgedampft wird, um ein Gemisch zu bilden, aus dem später zur Aktivierung der Kathode wieder Cäsium freigesetzt werden kann.

Von diesem Stand der Technik ausgehend ist es ein Ziel der Erfindung, eine Verdampferquelle der eingangs genannten Art anzugeben, welche im Hochvakuum Alkalimetalle erst bei Temperaturen über 200 °C abgibt und bei welcher eine Herstellung erleichtert ist.

Ein weiteres Ziel der Erfindung ist es, eine Vorrichtung der eingangs genannten Art anzugeben, welche bei erhöhten Temperaturen ausgeheizt werden kann, ohne dass es zur Bildung einer alkalimetallhältigen Gasphase kommt.

Ein weiteres Ziel der Erfindung besteht in der Angabe einer Verwendung für eine Legierung.

Das Ziel, eine Verdampferquelle zum Erzeugen einer Gasphase, die zumindest ein Alkalimetall aufweist oder aus diesem besteht, anzugeben, welche Verdampferquelle im Hochvakuum erst über 200 °C ein Alkalimetall abgibt und auf erleichterte Weise herstellbar ist, wird durch eine Verdampferquelle gemäß Anspruch 1 erreicht.

Das erfindungsgemäße Konzept beruht unter anderem auf der Beobachtung, dass eine schmelzmetallurgische Reaktion von Bismut mit Alkalimetallen oder Erdalkalimetallen, insbesondere Natrium, Kalium, Rubidium und Cäsium sehr stark exotherm verläuft. Umgekehrt betrachtet ergibt sich, dass ein gleich großer Energieeintrag benötigt wird, um ein Element aus dem Gitterverband bzw. der Schmelze wieder herauszulösen. Deswegen kann eine erfindungsgemäße Verdampferquelle in Hochvakuumvorrichtungen höheren Ausheiztemperaturen ausgesetzt werden als dies bisher der Fall war, ohne dass es zu einem unerwünschten Verdampfen eines Alkalimetalls kommt.

Anschließend, nach einem Ausheizen und bei einem Aktivieren der Verdampferquelle durch Beheizen der Legierung, ist ein genügend großer Partialdruck der Alkalimetalle über deren Legierungen mit Bismut gegeben, so dass eine alkalimetallhältige Gasphase erhalten werden kann. Dabei ist unter diesen Bedingungen ein Partialdruckunterschied von Bismut auf der einen Seite und den Alkalimetallen auf der anderen Seite genügend groß, um eine im Wesentlichen bismutfreie Gasphase eines Alkalimetalls zu erzeugen.

Bei Normaldruck, so hat sich weiter gezeigt, sind Schmelzen aus Bismut einerseits und einem Alkalimetall andererseits ausreichend stabil, d. h. die Schmelzen können bei Normaldruck verarbeitet werden, ohne dass das Alkalimetall aus diesen entweicht. Dies erlaubt eine einfache Verfahrensführung bei der Herstellung von Verdampferquellen.

Bevorzugte Verdampferquellen sind gegeben, wenn die Legierung Bismut und ein Alkalimetall enthält, da die Unterschiede in den Partialdrücken zwischen Bismut und Alkalimetallen besonders groß sind.

Bevorzugt kann es weiter sein, dass die Legierung mit einer etwa eutektischen Zusammensetzung vorliegt. Eine eutektische Zusammensetzung der Legierung erleichtert insbesondere eine Herstellung einer erfindungsgemäßen Verdampferquelle, da die Legierung in diesem Fall bei vergleichsweise niedrigen Temperaturen geschmolzen und verarbeitet werden kann. Dabei kann bei Normaldruck auf Grund von niedrigen Partialdampfdrücken von Alkalimetallen über der Schmelze eine stöchiometrische Zusammensetzung der Legierung während einer Weiterverarbeitung, z. B. Gießen oder Tropfen der Legierung, beibehalten werden.

In einer Variante der Erfindung besteht die Legierung aus Bismut und einem der Metalle Natrium, Kalium, Rubidium oder Cäsium. Die genannten Alkalimetalle zeichnen sich vor allem dadurch aus, dass ihr Partialdampfdruck bei erhöhten Temperaturen und im Hochvakuum viele Potenzen höher liegt als jener von Bismut. Dies ermöglicht es, Alkalimetalldämpfe mit besonders hoher Reinheit zur Verfügung zu stellen.

In diesem Zusammenhang hat es sich bewährt, Verdampferquellen einzusetzen, bei denen die Legierung 45 Atomprozent oder mehr Natrium, Kalium, Rubidium oder Cäsium aufweist. Derartige Legierungen haben den Vorteil, dass sie einen hohen Anteil des zu verdampfenden Alkalimetalls aufweisen und gegebenenfalls mit einer eutektischen Zusammensetzung bereitgestellt werden können.

Das weitere Ziel der Erfindung wird durch eine Vorrichtung der eingangs genannten Art erreicht, welche eine erfindungsgemäße Verdampferquelle umfasst.

Vorteile einer erfindungsgemäßen Vorrichtung sind insbesondere darin zu sehen, dass diese bei Temperaturen von mehr als 200 °C ausheizbar ist, ohne dass die Gefahr eines Verdampfens von Alkalimetall der Verdampferquelle gegeben ist. Dies erlaubt insbesondere bei Hochvakuumvorrichtungen eine effiziente Reinigung der Vorrichtung, was in der Folge wiederum eine Erzeugung einer besonders reinen, alkalimetallhältigen Gasphase ermöglicht.

Das weitere Ziel der Erfindung, eine Verwendung einer Legierung anzugeben, wird durch eine Verwendung einer Legierung gemäß Anspruch 6 erreicht.

Vorteile bei einer erfindungsgemäßen Verwendung einer Legierung ergeben sich insbesondere dadurch, dass Bismut mit Alkalimetallen sehr stabile Legierungen bildet, welche auch unter Hochvakuumbedingungen Alkalimetalle erst bei Temperaturen von über 200 °C abgeben. Dies erlaubt es, Vorrichtungen zur Umsetzung eines Alkalimetalls mit einer Substanz unter Vakuum auszuheizen und somit zu reinigen, ohne dass es zu einem unerwünschten Verdampfen eines Alkalimetalls kommt. In der Folge, nach einer Reinigung der Vorrichtung, kann ein eingesetztes Alkalimetall lokal noch weiter erwärmt werden, beispielsweise durch Widerstandsheizen, so dass eine alkalimetallmetallhältige Gasphase gebildet wird, welche anschließend mit einer Substanz umgesetzt wird. Umsetzung mit einer Substanz ist in diesem Zusammenhang umfassend zu verstehen und betrifft beispielsweise chemische Reaktionen unter Beteiligung eines Alkalimetalldampfes, Abscheiden von dünnen Schichten auf einen Träger, Dotieren von Festkörpern oder auch Gasphasenreaktionen.

Im Rahmen einer erfindungsgemäßen Verwendung ist es bevorzugt, dass die Legierung Bismut und ein Alkalimetall enthält. Bei einer erfindungsgemäß verwendeten Legierung weisen Alkalimetalle einerseits und Bismut andererseits im Hochvakuum bei erhöhten Temperaturen deutlich unterschiedliche Partialdampfdrücke auf, was die Erzeugung eines besonders reinen Alkalimetalldampfes ermöglicht.

Bevorzugt ist es weiter, einer guten Verarbeitbarkeit der Legierung wegen, wenn diese mit einer etwa eutektischen Zusammensetzung vorliegt.

Im Hinblick auf einen möglichst großen Unterschied in den Partialdampfdrücken zwischen einem Metall einerseits und Bismut andererseits ist es weiter bevorzugt, wenn die Legierung aus Bismut und Natrium, Kalium, Rubidium oder Cäsium besteht.

Im Zusammenhang damit kann vorgesehen sein, dass die Legierung 45 Atomprozent oder mehr Natrium, Kalium, Rubidium oder Cäsium aufweist. In diesem Fall weist eine Legierung einen hohen Anteil an nutzbarem Metall zur Erzeugung einer Gasphase auf, so dass bereits mit einer geringen Menge an Legierung die Herstellung einer gewünschten Gasphase erzielt werden kann.

Weitere Vorteile und Wirkungen der Erfindung ergeben sich aus dem Zusammenhang der Beschreibung und den nachfolgenden Ausführungsbeispielen.

Im Folgenden ist die Erfindung anhand von zwei lediglich beispielhaften Ausführungsformen noch weitergehend dargestellt.

Es zeigen:
Figur 1 eine Abkühlkurve für eine Schmelze bestehend aus 50 Atomprozent Cäsium und 50 Atomprozent Bismut;
Figur 2 einen Zusammenhang zwischen einem Heizstrom und einem zum Metalldampffluss proportionalen Detektorstrom für eine Verdampferquelle enthaltend eine Legierung bestehend aus 50 Atomprozent Cäsium und 50 Atomprozent Bismut;
Figur 3 einen Zusammenhang zwischen einer Temperatur und einem Heizstrom einer Verdampferquelle enthaltend eine Legierung aus Cäsium und Bismut;
Figur 4 einen Zusammenhang zwischen Heizstrom und Detektorstrom für eine Verdampferquelle enthaltend eine Legierung aus 33 Atomprozent Cäsium und 67 Atomprozent Bismut.

Erfindungsgemäße Verdampferquellen wurden erstellt, indem Bismut und ein Alkalimetall im Vakuum in einer abgeschlossenen Form aus Edelstahl geschmolzen und legiert wurden. Nach dem Legieren und Abkühlen auf Raumtemperatur wurde die Form in einer Schutzgasatmosphäre geöffnet, die Legierung entnommen und in einem elektrisch beheizbaren Behältnis untergebracht, um eine durch einen elektrischen Strom aktivierbare Verdampferquelle zu schaffen.

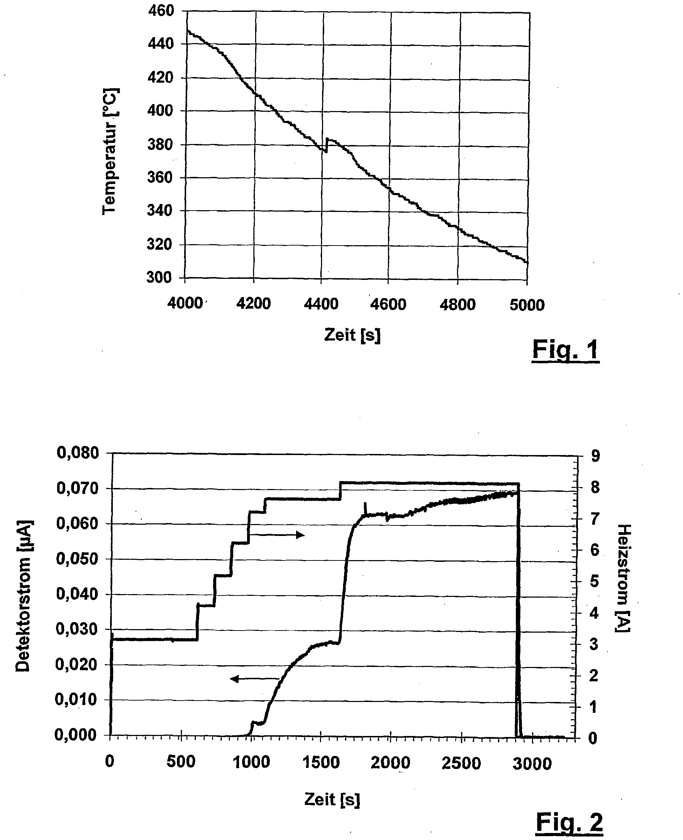

In Figur 1 ist eine Abkühlkurve, wie sie beim Abkühlen einer Schmelze bestehend aus 50 Atomprozent Cäsium und 50 Atomprozent Bismut erhalten wird, gezeigt. Aus dieser Kurve ist ersichtlich, dass bei einer Temperatur von etwa 385 °C ein Haltepunkt auftritt, was mit dem Phasendiagramm für Cäsium/Bismut übereinstimmt, welches bei der genannten Zusammensetzung ein Eutektikum zeigt. Die bei etwa 385 °C ersichtliche ausgeprägte eutektische Unterkühlung sowie der Haltepunkt bei 385 °C selbst zeigen an, dass eine Zusammensetzung der Schmelze beim Abkühlen im Wesentlichen konstant bleibt. Dies bedeutet, dass bei Normaldruck keine vorzeitige Cäsiumverdampfung auftritt und demgemäß eine entsprechende Schmelze aus jeweils 50 Atomprozent Cäsium bzw. Bismut bei Normaldruck auf einfache Weise verarbeitet werden kann, ohne dass diese während einer Verarbeitung ihre Zusammensetzung verändert.

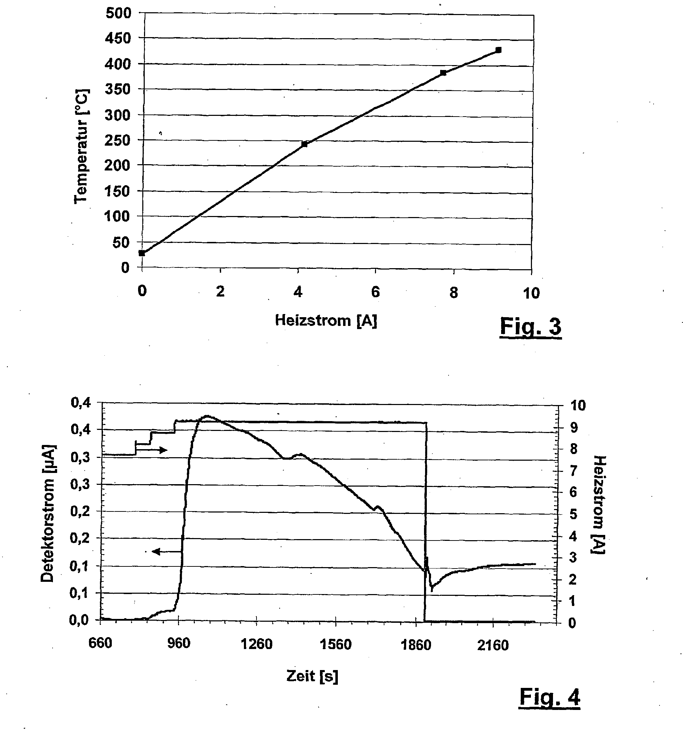

In Figur 2 ist eine Verdampfungscharakteristik einer Verdampferquelle enthaltend eine Legierung aus jeweils 50 Atomprozent Cäsium bzw. Bismut in Abhängigkeit von einem Heizstrom und für einen Druck von 10⁻⁶ mbar dargestellt. Es ist ersichtlich, dass erst bei einem Heizstrom von etwa 4,5 bis 5,5 A ein merklicher Detektorstrom und somit die Präsenz von Metalldampf registriert wird; dieser kann mit Hilfe bekannter Verfahren ermittelt werden, z. B. durch Messung mit einem Langmuir-Taylor-Detektor. Wie aus einer Eichkurve ablesbar ist (Figur 3), liegt bei einem Heizstrom von 4,5 bis 5,5 A eine Temperatur der Verdampferquelle etwa im Bereich von 250 bis 300 °C. Es folgt daher, dass bei dem gegebenen Druck eine Verdampferquelle enthaltend eine Legierung aus 50 Atomprozent Bismut erst ab einer Temperatur von ca. 250 °C gasförmiges Cäsium abgibt.

Aus Figur 2 ist weiter ersichtlich, dass bei Erreichen eines Heizstromes von etwa 8 A ein in einem engen Bereich liegender Detektorstrom gemessen wird. Das zeigt an, dass nach einer Induktionsperiode durch Anlegen eines konstanten Heizstromes eine cäsiumhältige Gasphase mit ungefähr gleich bleibender Zusammensetzung geschaffen werden kann, was günstig ist, wenn ein konstanter Stofffluss gefordert ist.

Ein weiteres Bespiel für eine Verdampferquelle ist anhand von Figur 4 veranschaulicht. In diesem Fall enthält die Verdampferquelle eine Legierung bestehend aus 33 Atomprozent Cäsium und 67 Atomprozent Bismut, wobei die Legierung wie vorstehend beschrieben hergestellt ist. Wie aus Figur 4 ablesbar, tritt bei Einsatz einer solchen Legierung eine Verdampfung von Cäsium erst bei einem Heizstrom von 8 A, also umgerechnet bei einer Temperatur von 350 bis 400 °C auf (siehe Figur 3). Für Anwendungen einer entsprechenden Verdampferquelle in Hochvakuumeinrichtungen bedeutet dies, dass die Hochvakuumeinrichtung bei 300 °C im Hochvakuum problemlos evakuiert und ausgeheizt werden kann, ohne dass die Gefahr einer vorzeitigen Abscheidung von Cäsium besteht.

Wenngleich die vorstehenden Bespiele jeweils eine Verdampferquelle betreffen, ist es auch möglich, dass mehrere Verdampferquellen gleichzeitig in einer Hochvakuumeinrichtung eingesetzt werden. Ebenso versteht es sich für den Fachmann, dass Bismut zum Teil durch ein oder mehrere Metalle ersetzt sein kann, solange ein geeignet hoher Anteil an Bismut für eine hohe Verdampfungstemperatur des Alkalimetalls unter Hochvakuumbedingungen sorgt. Eine besondere Reinheit des eingesetzten Bismuts ist nicht erforderlich.

Mögliche Einsatzgebiete einer erfindungsgemäßen Verdampferquelle betreffen, sind aber nicht beschränkt auf, Abscheiden von dünnen Alkalimetallschichten, bei einer Herstellung von Fotokathoden, Blitzlampen oder organischen Leuchtdioden oder als evaporierende Getter.

Eine erfindungsgemäße Verdampferquelle kann beispielsweise ein offenes, gegebenenfalls auch verschließbares Behältnis wie ein Metallröhrchen umfassen, welches elektrisch, z. B. mit einer um das Behältnis angebrachten Heizwendel, beheizbar ist, um die im Behältnis befindliche Legierung auf die für eine zum Freisetzen von Alkalimetall erforderliche Temperatur zu bringen. Besonders zweckmäßig ist es, Metallröhrchen einzusetzen, die mit einer vakuumdichten Dichtung eines bei niedrigen Temperaturen schmelzenden Materials (z. B. Gallium, Indium, Zinn, Blei oder eine Legierung dieser Metalle) versehen sind. Dadurch wird das im Inneren des Behältnisses befindliche Material bis zu dessen Aktivierung geschützt. Bei der Aktivierung selbst schmilzt dann zuerst die Dichtung, so dass in der Folge Alkalimetall aus dem Röhrchen entweichen kann.

## Patentansprüche

1. Verdampferquelle zum Erzeugen einer Gasphase, die zumindest ein Alkalimetall aufweist oder aus diesem besteht, welche Verdampferquelle eine Legierung aus Bismut und zumindest einem Alkalimetall der Metalle Natrium, Kalium, Rubidium und Cäsium enthält, wobei die Legierung mehr als 40 Atomprozent Alkalimetall aufweist.

2. Verdampferquelle nach Anspruch 1, wobei die Legierung mit einer etwa eutektischen Zusammensetzung vorliegt.

3. Verdampferquelle nach Anspruch 1 oder 2, wobei die Legierung aus Bismut und einem der Metalle Natrium, Kalium, Rubidium oder Cäsium besteht.

4. Verdampferquelle nach Anspruch 1, wobei die Legierung 45 Atomprozent oder mehr Natrium, Kalium, Rubidium oder Cäsium aufweist.

5. Vorrichtung mit einer Verdampferquelle zum Umsetzen einer Substanz mit einer Gasphase, welche zumindest ein Alkalimetall aufweist oder aus diesem besteht, insbesondere Hochvakuumvorrichtung, welche Vorrichtung eine Verdampferquelle nach einem der Ansprüche 1 bis 4 umfasst.

6. Verwendung einer Legierung, welche Bismut und zumindest ein Alkalimetall der Metalle Natrium, Kalium, Rubidium und Cäsium mit mehr als 40 Atomprozent enthält, zur Erzeugung einer Gasphase, welche zumindest ein Alkalimetall aufweist bzw. aus diesem besteht, und mit einer Substanz umgesetzt wird.

7. Verwendung einer Legierung nach Anspruch 6, wobei die Legierung mit einer etwa eutektischen Zusammensetzung vorliegt.

8. Verwendung einer Legierung nach Anspruch 6 oder 7, wobei die Legierung aus Bismut und Natrium, Kalium, Rubidium oder Cäsium besteht.

9. Verwendung einer Legierung nach einem der Ansprüche 6 bis 8, wobei die Legierung 45 Atomprozent oder mehr Natrium, Kalium, Rubidium oder Cäsium aufweist.

10. Verwendung einer Legierung nach einem der Ansprüche 6 bis 9 in einer Verdampferquelle zur Abscheidung von dünnen Alkalimetallschichten, welche bei einer Herstellung von Fotokathoden, Blitzlampen oder organischen Leuchtdioden oder als evaporierender Getter eingesetzt wird.

## Claims

1. A vaporising source for the generation of a gas phase, which comprises at least one alkali metal or consists thereof, which vaporising source comprises an alloy of bismuth and at least one alkali metal of the metals sodium, potassium, rubidium and caesium, wherein the alloy comprises more than 40 atomic percent of alkali metal.

2. The vaporising source according to claim 1, wherein the alloy is present with an approximately eutectic composition.

3. The vaporising source according to either claim 1 or claim 2, wherein the alloy consists of bismuth and one of the metals sodium, potassium, rubidium or caesium.

4. The vaporising source according to claim 1, wherein the alloy comprises 45 atomic percent or more of sodium, potassium, rubidium or caesium.

5. A device comprising a vaporising source for reacting a substance with a gas phase, which comprises at least one alkali metal or consists thereof, in particular a high-vacuum device, which device includes a vaporising source according to any one of claims 1 to 4.

6. A use of an alloy, which contains bismuth and at least one alkali metal of the metals sodium, potassium, rubidium and caesium at more than 40 atomic percent, for the generation of a gas phase, which comprises at least one alkali metal or consists thereof and is reacted with a substance.

7. The use of an alloy according to claim 6, wherein the alloy is present with an approximately eutectic composition.

8. The use of an alloy according to either claim 6 or claim 7, wherein the alloy consists of bismuth and sodium, potassium, rubidium or caesium.

9. The use of an alloy according to any one of claims 6 to 8, wherein the alloy comprises 45 atomic percent or more of sodium, potassium, rubidium or caesium.

10. The use of an alloy according to any one of claims 6 to 9 in a vaporising source for the deposition of thin alkali metal films, which is used in the production of photocathodes, flashbulbs or organic LEDs or as an evaporating getter.

## Revendications

1. Source de vaporisation pour créer une phase gazeuse, qui comporte au moins un métal alcalin ou qui consiste dans ce dernier, laquelle source de vaporisation contient un alliage de bismuth et d'au moins un métal alcalin des métaux sodium, potassium, rubidium et césium, l'alliage comportant plus de 40 titres molaires de métal alcalin.

2. Source de vaporisation selon la revendication 1, l'alliage étant présent dans une composition approximativement eutectique.

3. Source de vaporisation selon la revendication 1 ou 2, l'alliage étant constitué de bismuth et de l'un des métaux sodium, potassium, rubidium ou césium.

4. Source de vaporisation selon la revendication 1, l'alliage comportant 45 titres molaires ou plus de sodium, de potassium, de rubidium ou de césium.

5. Dispositif avec une source de vaporisation pour transformer une substance avec une phase gazeuse, laquelle comporte au moins un métal alcalin ou est constituée de ce dernier, notamment dispositif à vide poussé, lequel dispositif comprend une source de vaporisation selon l'une quelconque des revendications 1 à 4.

6. Utilisation d'un alliage, lequel contient du bismuth et au moins un métal alcalin des métaux sodium, potassium, rubidium et césium dans une quantité supérieure à 40 titres molaires, pour créer une phase gazeuse, laquelle comporte au moins un métal alcalin ou est constituée de ce dernier et qui est transformée avec une substance.

7. Utilisation d'un alliage selon la revendication 6, l'alliage étant présent dans une composition approximativement eutectique.

8. Utilisation d'un alliage selon la revendication 6 ou 7, l'alliage étant constitué de bismuth et de sodium, de potassium, de rubidium ou de césium.

9. Utilisation d'un alliage selon l'une quelconque des revendications 6 à 8, l'alliage comportant 45 titres molaires ou plus de sodium, de potassium, de rubidium ou de césium.

10. Utilisation d'un alliage selon l'une quelconque des revendications 6 à 9 dans une source de vaporisation pour le dépôt de minces couches de métal alcalin, laquelle est utilisée pour la fabrication de cathodes photos, de lampes éclairs ou de diodes électroluminescentes organiques ou en tant que getter à évaporation.
